# EUROPÄISCHE PATENTANMELDUNG

(11) **EP 4 432 544 A1**
(43) Veröffentlichungstag der Anmeldung: **18.09.2024**
(21) Anmeldenummer: 24158493.7
(22) Anmeldetag: 19.02.2024
(51) Int. Cl.: H02M 7/48, H02M 1/12, H02M 1/44, H02M 1/32, G01R 31/40, G01R 31/26, G01R 31/28

(54) **VERFAHREN ZUM ÜBERWACHEN EINES EINGANGSFILTERS EINES STROMRICHTERS UND STROMRICHTERANORDNUNG**

(30) Priorität: 14.03.2023 DE 102023202301
(71) Anmelder: Volkswagen Aktiengesellschaft, 38440 Wolfsburg (DE)
(72) Erfinder: Kube, Adrian, 91097 Oberreichenbach (DE); Köster, Robert, 38518 Gifhorn (DE)

(57) **Zusammenfassung**

Die Erfindung betrifft ein Verfahren zum Überwachen eines Eingangsfilters (3) eines Stromrichters (2), wobei das Eingangsfilter (3) eingangsseitig mit einer Gleichspannungs-Hochspannungsversorgung (4) verbunden ist, wobei ein Testsignal (11) auf das Eingangsfilter (3) aufgeprägt wird, wobei ein aus dem Testsignal (11) nach Durchlaufen des Eingangsfilters (3) resultierendes Signal (13) mittels Erfassungsmitteln (6) erfasst wird, und wobei das erfasste resultierende Signal (13) ausgewertet wird und ein Auswertungsergebnis (14) bereitgestellt wird. Ferner betrifft die Erfindung eine Stromrichteranordnung (1).

## Beschreibung

Die Erfindung betrifft ein Verfahren zum Überwachen eines Eingangsfilters eines Stromrichters und eine Stromrichteranordnung.

In Stromrichtern, die für Traktionsumrichter eingesetzt werden, werden (EMV-)Eingangsfilter an einem Gleichspannungs-Hochspannungseingang verwendet, um EMV-Störungen zu begrenzen. Diese Eingangsfilter sind lineare Netzwerke aus Kondensatoren und Ferriten (Induktivitäten). Ein Zustand dieser Bauteile wird während des Betriebes nicht überwacht. Es ist jedoch bekannt, eine Temperatur mittels Temperatursensoren zu erfassen, um eine Übertemperatur festzustellen. Solche Temperatursensoren sind jedoch aufwändig in der Anbindung und können zu Überkopplungen am Eingangsfilter vorbeiführen.

Der Erfindung liegt die Aufgabe zu Grunde, ein Verfahren zum Überwachen eines Eingangsfilters eines Stromrichters und eine Stromrichteranordnung zu schaffen.

Die Aufgabe wird erfindungsgemäß durch ein Verfahren mit den Merkmalen des Patentanspruchs 1 und eine Stromrichteranordnung mit den Merkmalen des Patentanspruchs 11 gelöst. Vorteilhafte Ausgestaltungen der Erfindung ergeben sich aus den Unteransprüchen.

Insbesondere wird ein Verfahren zum Überwachen eines Eingangsfilters eines Stromrichters zur Verfügung gestellt, wobei das Eingangsfilter eingangsseitig mit einer Gleichspannungs-Hochspannungsversorgung verbunden ist, wobei ein Testsignal auf das Eingangsfilter aufgeprägt wird, wobei ein aus dem Testsignal nach Durchlaufen des Eingangsfilters resultierendes Signal mittels Erfassungsmitteln erfasst wird, und wobei das erfasste resultierende Signal ausgewertet wird und ein Auswertungsergebnis bereitgestellt wird.

Ferner wird insbesondere eine Stromrichteranordnung geschaffen, umfassend einen Stromrichter mit einem Eingangsfilter, eine Gleichspannungs-Hochspannungsversorgung, welche mit dem Eingangsfilter verbunden ist, Signalerzeugungsmittel, die dazu eingerichtet sind, ein Testsignal auf das Eingangsfilter aufzuprägen, Erfassungsmittel, die dazu eingerichtet sind, ein aus dem Testsignal nach Durchlaufen des Eingangsfilters resultierendes Signal zu erfassen, und eine Auswertungseinrichtung, die dazu eingerichtet ist, das erfasste resultierende Signal auszuwerten und ein Auswertungsergebnis bereitzustellen.

Das Verfahren und die Stromrichteranordnung ermöglichen es, das Eingangsfilter zu überprüfen. Hierzu wird ein Testsignal auf das Eingangsfilter mittels Signalerzeugungsmitteln aufgeprägt und ein aus dem Testsignal nach Durchlaufen des Eingangsfilters resultierendes Signal mittels Erfassungsmitteln erfasst. Das erfasste resultierende Signal wird mittels einer Auswertungseinrichtung ausgewertet und ein Auswertungsergebnis wird bereitgestellt. Dem liegt der Gedanke zugrunde, dass mit Hilfe eines bekannten Testsignals eine Funktion des Eingangsfilters überprüft werden kann. Das Eingangsfilter hat insbesondere die Funktion, Hochfrequenzsignale mit einem definierten Abschwächungsfaktor abzuschwächen. Diese Abschwächung kann mit Hilfe des aufgeprägten Testsignals überprüft werden, wenn das Testsignal nach Durchlaufen des Eingangsfilters erfasst und ausgewertet wird. Dies kann beispielsweise durch Vergleich des resultierenden Signals mit dem Testsignal erfolgen. Mögliche Auswertungsergebnisse sind zum Beispiel, dass das Testsignal eine Ausgangsseite des Eingangsfilters überhaupt nicht erreicht oder dass eine Dämpfung nicht in dem Maße erfolgt, wie dies gemäß einer Sollvorgabe (vorgegebene Übertragungsfunktion) vorgesehen ist.

Das Eingangsfilter ist insbesondere ein EMV-Eingangsfilter, das dazu dient, eine elektromagnetische Verträglichkeit (EMV) des Stromrichters sicherzustellen. Das Eingangsfilter umfasst insbesondere ein lineares Netzwerk aus Kapazitäten und Induktivitäten bzw. aus Kondensatoren und Ferritkernen. Signaltechnisch kann das Eingangsfilter insbesondere als Vierpol betrachtet werden. Es ist insbesondere vorgesehen, das Testsignal auf einer Seite aufzuprägen, auf der die Verbindung zur Gleichspannungs-Hochspannungsversorgung besteht und auf der anderen Seite des Eingangsfilters das resultierende Signal zu erfassen. Grundsätzlich ist es jedoch auch möglich, das Testsignal auf der Seite des Stromrichters aufzuprägen und auf der anderen Seite, die mit der Gleichspannungs-Hochspannungsversorgung verbunden ist, zu erfassen.

Der Stromrichter ist insbesondere ein Pulswechselrichter (PWR), der dazu dient, Phasenströme für eine elektrische Maschine, insbesondere in einem (Kraft-)Fahrzeug, bereitzustellen. Der Stromrichter umfasst insbesondere Stromsensoren zum Erfassen der erzeugten Phasenströme sowie eine Steuereinrichtung, welche dazu eingerichtet ist, ausgehend von den von den Stromsensoren bereitgestellten Signalen und einer Drehmomentanforderung Halbleiterschalter von Halbbrücken des Stromrichters anzusteuern. Die Steuereinrichtung kann hierzu eine Modulationssteuerung zum Erzeugen von Pulsmustern umfassen.

Das Testsignal ist insbesondere ein amplitudenmoduliertes Signal (AM). Das Testsignal weist insbesondere eine Frequenz in einem Bereich auf, in dem das Eingangsfilter aktiv ist. Bei einer Anwendung des Stromrichters als Umrichter für eine elektrische Maschine liegt eine Frequenz des Testsignals insbesondere in einem Bereich von 10 bis 20 kHz. Grundsätzlich können jedoch auch andere Frequenzen vorgesehen sein, beispielsweise mit einem 30-, 40- oder 80-kHz-Täger. Es kann vorgesehen sein, dass das Testsignal aus mehreren Frequenzen oder Frequenzanteilen zusammengesetzt ist. Es können hierbei insbesondere auch komplexere Signalformen (Pulse, Pulsfolgen etc.) zum Einsatz kommen. Es kann auch vorgesehen sein, dass eine Frequenz über das Testsignal hinweg geändert wird (z.B. Chirp). Mit Hilfe von Signalformen, welche mehrere Grundfrequenzen umfassen, können beispielsweise definierte Dämpfungen des Eingangsfilters für bestimmte Frequenzbereiche überprüft werden.

Teile der Stromrichteranordnung, insbesondere die Signalerzeugungsmittel, die Erfassungsmittel und die Auswertungseinrichtung sowie eine Steuereinrichtung des Stromrichters, können einzeln oder zusammengefasst als eine Kombination von Hardware und Software ausgebildet sein, beispielsweise als Programmcode, der auf einem Mikrocontroller oder Mikroprozessor ausgeführt wird. Es kann jedoch auch vorgesehen sein, dass Teile einzeln oder zusammengefasst als anwendungsspezifische integrierte Schaltung (ASIC) und/oder feldprogrammierbares Gatterfeld (FPGA) ausgebildet sind.

In einer Ausführungsform ist vorgesehen, dass ausgehend von dem Auswertungsergebnis mindestens eine Aktion veranlasst wird. Hierdurch kann direkt und automatisiert auf das Auswertungsergebnis reagiert werden. Wird beispielsweise festgestellt, dass das Eingangsfilter sich nicht in einem normalen Betriebszustand befindet, so können Maßnahmen ergriffen werden, um wieder zum normalen Betriebszustand zurückzukehren.

In einer Ausführungsform ist vorgesehen, dass das Auswerten ein Überprüfen umfasst, ob das Testsignal in dem erfassten resultierenden Signal enthalten ist. Hierdurch kann überprüft werden, ob das Testsignal das Eingangsfilter durchlaufen hat oder nicht. Ist das Testsignal nicht in dem erfassten resultierenden Signal enthalten, so kann dies beispielsweise an einer unterbrochenen oder fehlerhaften Hochspannungsverbindung zwischen der Gleichspannungs-Hochspannungsversorgung und dem Stromrichter oder an einem Defekt innerhalb des Eingangsfilters liegen. Es ist insbesondere vorgesehen, dass auch ein verfälschtes Testsignal in dem erfassten resultierenden Signal als Testsignal erkannt wird. Das Überprüfen dient insbesondere der Feststellung, dass überhaupt eine Reaktion des Eingangsfilters auf das Testsignal erfasst wurde.

In einer Ausführungsform ist vorgesehen, dass das Auswerten ein Überprüfen umfasst, ob das erfasste resultierende Signal einen vorgegebenen Signalpegel aufweist. Hierdurch kann eine vorgegebene Dämpfung überprüft werden. Es kann hierbei insbesondere auch vorgesehen sein, dass ein Spektrum des erfassten resultierenden Signals ausgewertet wird. Beispielsweise kann ein frequenzabhängiges Verhalten des Eingangsfilters aus einem Vergleich zwischen dem Testsignal und dem resultierenden Signal bestimmt werden und mit einem erwarteten bzw. vorgegebenen Verhalten (frequenzabhängige Dämpfung und/oder vorgegebene Übertragungsfunktion) verglichen werden.

In einer Ausführungsform ist vorgesehen, dass das Testsignal mittels eines zum Vorladen einer Hochspannungsverbindung zwischen der Gleichspannungs-Hochspannungsversorgung und dem Eingangsfilter verwendeten konfigurierbaren Netzteils erzeugt und aufgeprägt wird. Hierdurch können insbesondere bereits vorhandene Bauteile verwendet werden, sodass Aufwand, Bauraum und Kosten eingespart werden können. Das konfigurierbare Netzteil ist insbesondere in der Gleichspannungs-Hochspannungsversorgung angeordnet. Durch eine geeignete Konfiguration kann das Netzteil dazu verwendet werden, das Testsignal auf die Hochspannungsverbindung und hierdurch auf das hiermit verbundene Eingangsfilter aufzuprägen.

In einer Ausführungsform ist vorgesehen, dass ausgehend von ausgangsseitig am Stromrichter erfassten Phasenströmen ein eingangsseitiger Gleichstrom am Stromrichter bestimmt wird oder dass der eingangsseitige Gleichstrom mittels einer Sensorik erfasst wird, wobei zusätzlich überprüft wird, ob der bestimmte oder erfasste Gleichstrom einen vorgegebenen Schwellwert überschreitet, wobei ein Überprüfungsergebnis beim Veranlassen der mindestens einen Aktion berücksichtigt wird. Hierdurch kann insbesondere ein Sättigungsfehler erkannt werden. Ein solcher Sättigungsfehler tritt auf, wenn das Magnetfeld an den Ferritkernen des Eingangsfilters gesättigt ist und die Magnetfeldlinien dann einen Weg außerhalb der Ferritkerne nehmen. Dies kann zu einer Änderung der Filtereigenschaften des Eingangsfilters führen, sodass dieser nicht mehr korrekt arbeitet.

In einer Ausführungsform ist vorgesehen, dass ausgehend von einem thermischen Modell des Stromrichters und des Eingangsfilters eine Temperatur von Ferritkernen des Eingangsfilters bestimmt wird, wobei zusätzlich überprüft wird, ob die bestimmte Temperatur die Curie-Temperatur der Ferritkerne überschreitet oder nicht, wobei ein Überprüfungsergebnis beim Veranlassen der mindestens einen Aktion berücksichtigt wird. Hierdurch kann überprüft werden, ob die Ferritkerne noch magnetische Eigenschaften aufweisen oder diese aufgrund einer zu hohen Temperatur verloren haben. Verlieren die Ferritkerne ihre magnetischen Eigenschaften, so verändern sich die Filtereigenschaften des Eingangsfilters. Das thermische Modell ist insbesondere ein Modell, das in an sich bekannter Weise ausgehend von erfassten oder bestimmten Größen (insbesondere Phasenströmen und Phasenspannungen) sowie einem zeitlichen Verlauf dieser Messgrößen einen Wärmeeintrag in die und/oder eine Temperatur der Ferritkerne schätzt. Hierbei wird insbesondere auch eine zeitliche Historie berücksichtigt. So führen größere Phasenströme in der Regel auch zu einem größeren Gleichstrom durch das Eingangsfilter und hierdurch zu einem erhöhten Wärmeeintrag in das Eingangsfilter.

In einer Ausführungsform ist vorgesehen, dass als Aktion eine Leistungsherabsetzung für eine vorgegebene erste Zeitdauer veranlasst wird, sofern das Testsignal in dem resultierenden Signal enthalten ist und das erfasste resultierende Signal den vorgegebenen Signalpegel überschreitet und der bestimmte oder erfasste Gleichstrom den vorgegebenen Schwellwert überschreitet. Hierdurch kann insbesondere eine Sättigung des Magnetfeldes der Ferritkerne behoben werden. Durch die Leistungsherabsetzung, welche durch Anfordern eines verringerten Drehmoments bewirkt werden kann, reduzieren sich die Phasenströme und in der Folge auch ein Gleichstrom durch das Eingangsfilter. Hierdurch kann eine Entsättigung erreicht werden, sodass die Ferritkerne im Anschluss wieder wie vorgesehen arbeiten und das Eingangsfilter seine ursprünglichen Filtereigenschaften zurückerhält. Die Auswertungseinrichtung erzeugt und übermittelt hierzu insbesondere Steuersignale zur Leistungsherabsetzung an eine Modulationsteuerung des Stromrichters. Die erste Zeitdauer ist insbesondere kurz gewählt, das heißt, es handelt sich insbesondere um eine Leistungsherabsetzung im Sekundenbereich.

In einer Ausführungsform ist vorgesehen, dass als Aktion eine Leistungsherabsetzung für eine vorgebebene zweite Zeitdauer veranlasst wird, sofern das Testsignal in dem resultierenden Signal enthalten ist und das erfasste resultierende Signal den vorgegebenen Signalpegel überschreitet und die Curie-Temperatur der Ferritkerne überschritten ist. Hierdurch kann insbesondere eine Temperatur der Ferritkerne reduziert werden, sodass diese wieder unterhalb der Curie-Temperatur liegt und die Ferritkerne des Eingangsfilters wieder ihre magnetischen Eigenschaften zurückerlangen. Durch die Leistungsherabsetzung, welche durch Anfordern eines verringerten Drehmoments bewirkt werden kann, reduzieren sich die Phasenströme und in der Folge auch ein Gleichstrom durch das Eingangsfilter. Durch den verringerten Gleichstrom ist auch ein Wärmeeintrag in die Ferritkerne reduziert, sodass die Temperatur der Ferritkerne wieder sinken kann. Sinkt die Temperatur unter die Curie-Temperatur, so erlangen die Ferritkerne ihre magnetischen Eigenschaften wieder zurück. Die Auswertungseinrichtung erzeugt und übermittelt hierzu insbesondere Steuersignale zur Leistungsherabsetzung an eine Modulationssteuerung des Stromrichters. Die zweite Zeitdauer ist insbesondere länger als die erste Zeitdauer gewählt, das heißt, es handelt sich insbesondere um eine Leistungsherabsetzung im Minutenbereich.

In einer Ausführungsform ist vorgesehen, dass als Aktion ein Fehlersignal erzeugt und/oder bereitgestellt wird, wenn das erfasste resultierende Signal den vorgegebenen Signalpegel unterschreitet. Hierdurch kann angezeigt werden, dass es insbesondere ein Problem mit der Hochspannungsverbindung zwischen der Hochspannungsversorgung und dem Stromrichter bzw. dem Eingangsfilter gibt.

In einer Ausführungsform ist vorgesehen, dass zusätzlich eine Isolation mittels eines Isolationswächters überprüft wird, wobei ein Überprüfungsergebnis beim Veranlassen der mindestens einen Aktion berücksichtigt wird. Der Isolationswächter kann hierbei beispielsweise in der Gleichspannungs-Hochspannungsversorgung angeordnet sein. Das Überprüfen der Isolation erfolgt ansonsten in an sich bekannter Weise.

Nach dem Durchführen des Verfahrens kann vorgesehen sein, das Verfahren zu wiederholen, insbesondere in regelmäßigen Abständen.

Weitere Merkmale zur Ausgestaltung der Stromrichteranordnung ergeben sich aus der Beschreibung von Ausgestaltungen des Verfahrens. Die Vorteile der Stromrichteranordnung sind hierbei jeweils die gleichen wie bei den Ausgestaltungen des Verfahrens.

Nachfolgend wird die Erfindung anhand bevorzugter Ausführungsbeispiele unter Bezugnahme auf die Figuren näher erläutert. Hierbei zeigen:
- Fig. 1: eine schematische Darstellung einer Ausführungsform der Stromrichteranordnung;
- Fig. 2: ein schematisches Ablaufdiagramm einer Ausführungsform des Verfahrens zum Überwachen eines Eingangsfilters eines Stromrichters.

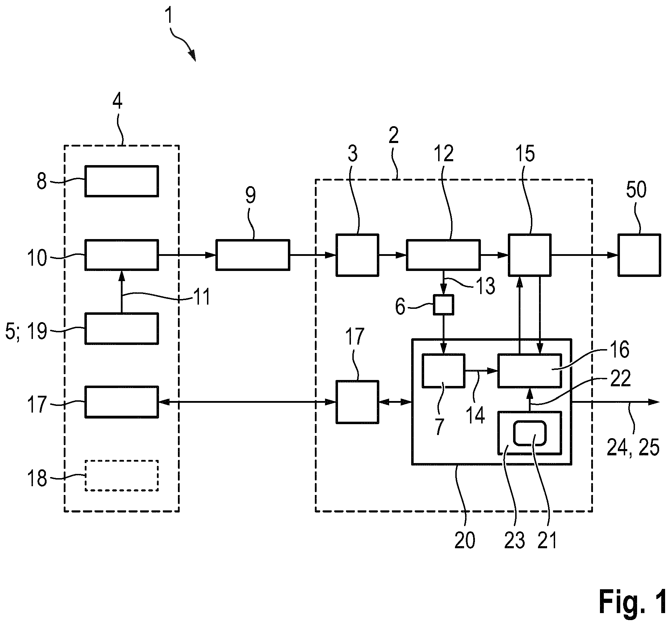

Die Fig. 1 zeigt eine schematische Darstellung einer Ausführungsform der Stromrichteranordnung 1. Die Stromrichteranordnung 1 umfasst einen Stromrichter 2 mit einem Eingangsfilter 3, eine Gleichspannungs-Hochspannungsversorgung 4, Signalerzeugungsmittel 5, Erfassungsmittel 6 und eine Auswertungseinrichtung 7.

Die Gleichspannungs-Hochspannungsversorgung 4 umfasst eine Hochvoltbatterie 8 zur Spannungsversorgung. Die Gleichspannungs-Hochspannungsversorgung 4 ist über eine Hochspannungsverbindung 9 mit dem Eingangsfilter 3 verbunden.

Die Signalerzeugungsmittel 5 sind mittels einer Einkoppeleinrichtung 10 mit der Hochspannungsverbindung 9 verbunden. Die Einkoppeleinrichtung 10 kann zum Einkoppeln beispielsweise einen Kondensator (nicht gezeigt) oder einen Trafo (nicht gezeigt) umfassen. Die Signalerzeugungsmittel 5 sind dazu eingerichtet, ein Testsignal 11 auf das Eingangsfilter 3 aufzuprägen. Das Testsignal 11 durchläuft das Eingangsfilter 3 und wird von dem Eingangsfilter 3 gedämpft. Mittels einer Auskoppeleinrichtung 12 erfassen die Erfassungsmittel 6 ein aus dem Testsignal 11 nach Durchlaufen des Eingangsfilters 3 resultierendes Signal 13. Die Auskoppeleinrichtung 12 kann zum Auskoppeln beispielsweise einen Kondensator (nicht gezeigt) oder einen Trafo (nicht gezeigt) umfassen.

Die Erfassungsmittel 6 sind beispielsweise als zeitaufgelöst messende Spannungserfassungseinrichtung ausgebildet oder umfassen eine solche. Das erfasste resultierende Signal 13 wird der Auswertungseinrichtung 7 zugeführt. Die Auswertungseinrichtung 7 ist dazu eingerichtet, das erfasste resultierende Signal 13 auszuwerten und ein Auswertungsergebnis 14 bereitzustellen.

Ferner umfasst der Stromrichter 2 insbesondere einen Pulswechselrichter 15, der beispielsweise mit einer elektrischen Maschine 50 (insbesondere in einem Fahrzeug) verbunden ist und Phasenspannungen für diese bereitstellt, sowie eine Kommunikationsschnittstelle 17, beispielsweise eine Controller Area Network (CAN)-Schnittstelle. Der Pulswechselrichter 15 wird mittels einer Modulationssteuerung 16 gesteuert oder geregelt.

Es kann vorgesehen sein, dass die Auswertungseinrichtung 7 und die Modulationssteuerung 16 als gemeinsame Steuereinrichtung 20 des Stromrichters 2 ausgebildet sind oder von dieser umfasst sind.

Die Gleichspannungs-Hochspannungsversorgung 4 umfasst ferner insbesondere ebenfalls eine Kommunikationsschnittstelle 17. Weiter kann die Gleichspannungs-Hochspannungsversorgung 4 einen Isolationswächter 18 aufweisen, mit dem eine Isolation in an sich bekannter Weise überwacht und/oder überprüft werden kann.

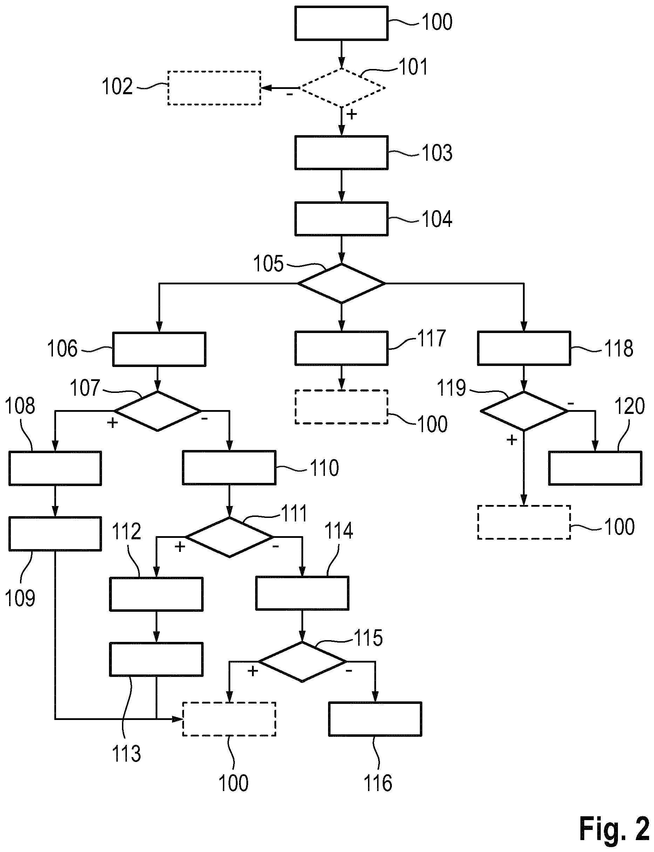

Es kann vorgesehen sein, dass ausgehend von dem Auswertungsergebnis 14 mindestens eine Aktion veranlasst wird. Hierzu wird das Auswertungsergebnis 14 insbesondere der Modulationssteuerung 16 zugeführt. Die Modulationsteuerung 16 ist insbesondere dazu eingerichtet, ausgehend von dem übermittelten Auswertungsergebnis 14 die mindestens eine Aktion zu bestimmen und/oder auszuwählen und zu veranlassen. Die mindestens eine Aktion kann aber grundsätzlich auch von einer anderen Einrichtung, beispielsweise einem hierfür eingerichteten Modul der Steuereinrichtung 20, bestimmt und/oder ausgewählt und veranlasst werden. Das Bestimmen kann beispielsweise ausgehend von einem Entscheidungsbaum erfolgen, der in Abhängigkeit von dem Auswertungsergebnis 14, und optional in Abhängigkeit von weiteren Informationen, die zu veranlassende mindestens eine Aktion vorgibt (vgl. auch Fig. 2).

Es kann vorgesehen sein, dass das Auswerten ein Überprüfen umfasst, ob das Testsignal 11 in dem erfassten resultierenden Signal 13 enthalten ist. Dies wird mittels der Auswertungseinrichtung 7 durchgeführt, welche beispielsweise frequenzabhängig eine Amplitude ausgewertet und/oder eine Mustererkennung und/oder eine Korrelation mit dem Testsignal 11 durchführt. Das Auswertungsergebnis 14 umfasst dann eine Information darüber, ob das Testsignal 11 in dem erfassten resultierenden Signal 13 enthalten ist oder nicht.

Es kann vorgesehen sein, dass das Auswerten ein Überprüfen umfasst, ob das erfasste resultierende Signal 13 einen vorgegebenen Signalpegel aufweist. Dies wird mittels der Auswertungseinrichtung 7 durchgeführt, welche beispielsweise eine Amplitude des resultierenden Signals 13 auswertet und mit einem vorgegebenen Schwellwert für den vorgegebenen Signalpegel vergleicht. Das Auswertungsergebnis 14 umfasst dann eine Information darüber, ob das resultierenden Signal 13 den vorgegebenen Signalpegel erreicht oder nicht.

Es kann vorgesehen sein, dass das Testsignal 13 mittels eines zum Vorladen der Hochspannungsverbindung 9 zwischen der Gleichspannungs-Hochspannungsversorgung 4 und dem Eingangsfilter 3 verwendeten konfigurierbaren Netzteils 19 erzeugt und aufgeprägt wird.

Die Signalerzeugungsmittel 5 umfassen dann das konfigurierbare Netzteile 19 oder werden durch dieses ausgebildet.

Es kann vorgesehen sein, dass ausgehend von ausgangsseitig am Stromrichter 2 erfassten Phasenströmen ein eingangsseitiger Gleichstrom am Stromrichter 2 bestimmt wird oder dass der eingangsseitige Gleichstrom mittels einer Sensorik (nicht gezeigt) erfasst wird, wobei zusätzlich überprüft wird, ob der bestimmte oder erfasste Gleichstrom einen vorgegebenen Schwellwert überschreitet, wobei ein Überprüfungsergebnis beim Veranlassen der mindestens einen Aktion berücksichtigt wird. Dies wird mittels der Auswertungseinrichtung 7 durchgeführt, welche beispielsweise den Gleichstrom bestimmt oder den bestimmten Gleichstrom von der Modulationssteuerung 16 oder den erfassten Gleichstrom von der Sensorik erhält und diesen mit dem vorgegebenen Schwellwert vergleicht. Das Auswertungsergebnis 14 umfasst dann eine Information darüber, ob der Schwellwert für den bestimmten oder erfassten Gleichstrom überschritten ist oder nicht.

Es kann vorgesehen sein, dass ausgehend von einem thermischen Modell 21 des Stromrichters 2 und des Eingangsfilters 3 eine Temperatur von Ferritkernen des Eingangsfilters 3 bestimmt wird, wobei zusätzlich überprüft wird, ob die bestimmte Temperatur die Curie-Temperatur der Ferritkerne überschreitet oder nicht, wobei ein Überprüfungsergebnis 22 beim Veranlassen der mindestens einen Aktion berücksichtigt wird. Das thermische Modell 21 ist beispielsweise in einer Simulationseinrichtung 23 hinterlegt und wird von dieser angewandt, um ausgehend von erfassten Phasenströmen und Phasenspannungen, und optional von weiteren Größen, eine Entwicklung der Eigenschaften des Stromrichters 2 und des Eingangsfilters 3 im Zeitverlauf zu bestimmen, insbesondere zu schätzen. Hierbei werden insbesondere in Bauelementen des Stromrichters 2 und des Eingangsfilters 3 auftretende Leistungen bestimmt und im zeitlichen Verlauf berücksichtigt, um eine Erwärmung und hierüber eine Veränderung der physikalischen Eigenschaften des Stromrichters 2 und des Eingangsfilters 3 zu bestimmen, insbesondere zu schätzen.

Es kann vorgesehen sein, dass als Aktion eine Leistungsherabsetzung für eine vorgegebene erste Zeitdauer veranlasst wird, sofern das Testsignal 11 in dem resultierenden Signal 13 enthalten ist und das erfasste resultierende Signal 13 den vorgegebenen Signalpegel überschreitet und der bestimmte oder erfasste Gleichstrom den vorgegebenen Schwellwert überschreitet. Hierzu verändert die Modulationssteuerung 16 beispielsweise ein Pulsmuster beim Steuern oder Regeln des Pulswechselrichters 15 derart, dass ein Drehmoment und eine Leistung reduziert werden. Dies erfolgt insbesondere für die vorgegebene erste Zeitdauer, insbesondere für einige Sekunden. Anschließend wird insbesondere wieder zum vorherigen Pulsmuster zurückgekehrt.

Es kann vorgesehen sein, dass als Aktion eine Leistungsherabsetzung für eine vorgebebene zweite Zeitdauer veranlasst wird, sofern das Testsignal 11 in dem resultierenden Signal 13 enthalten ist und das erfasste resultierende Signal 13 den vorgegebenen Signalpegel überschreitet und die Curie-Temperatur der Ferritkerne überschritten ist. Hierzu verändert die Modulationssteuerung 16 beispielsweise ein Pulsmuster beim Steuern oder Regeln des Pulswechselrichters 15 derart, dass ein Drehmoment und eine Leistung reduziert werden. Dies erfolgt insbesondere für die vorgegebene zweite Zeitdauer, insbesondere für einige Minuten. Anschließend wird insbesondere wieder zum vorherigen Pulsmuster zurückgekehrt.

Es kann vorgesehen sein, dass als Aktion ein Fehlersignal 24 als Statussignal 25 erzeugt und/oder bereitgestellt wird, wenn das erfasste resultierende Signal 13 den vorgegebenen Signalpegel unterschreitet.

Es kann generell vorgesehen sein, dass ausgehend von dem Auswertungsergebnis 14 ein jeweiliges Statussignal 25 bereitgestellt und/oder aktualisiert wird.

Es kann vorgesehen sein, dass das Testsignal 11 im Stromrichter 2 auf das Eingangsfilter 3 aufgeprägt wird und das resultierende Signal 13 auf der Seite der Gleichspannungs-Hochspannungsversorgung 4 erfasst und ausgewertet wird. Eine Laufrichtung des Testsignals 11 durch das Eingangsfilter 3 ist dann umgekehrt. Das Testsignal 11 kann im Stromrichter 2 beispielsweise mittels eines Gleichspannungswandlers (nicht gezeigt) erzeugt werden, der als Hochspannungs-Niedrigspannungs-Wandler dient und die Modulationssteuerung 16 bzw. die Steuereinrichtung 20 und weitere Einrichtungen des Stromrichters 2 bei einem Ausfall einer ansonsten verwendeten Niedrigspannungsversorgung mit Energie versorgt.

Die Fig. 2 zeigt ein schematisches Ablaufdiagramm einer Ausführungsform des Verfahrens zum Überwachen eines Eingangsfilters eines Stromrichters.

In einem Verfahrensschritt 100 wird das Verfahren gestartet.

In einem optionalen Verfahrensschritt 101 wird eine Isolation der Hochspannungsverbindung zwischen der Gleichspannungs-Hochspannungsversorgung und dem Stromrichter überprüft.

Sofern ein Isolationsfehler vorliegt, wird in einem Verfahrensschritt 102 eine Fehlermeldung erzeugt und die Stromrichteranordnung in einen sicheren Zustand überführt, beispielsweise indem Sicherheitsschütze der Gleichspannungs-Hochspannungsversorgung geöffnet werden, und eine Fehlermeldung erzeugt. Sofern die Stromrichteranordnung in einem Fahrzeug angeordnet ist, wird das Fahrzeug vorher in einen sicheren Zustand überführt.

Ist die Isolation hingegen in Ordnung, so wird in einem Verfahrensschritt 103 ein Testsignal auf das Eingangsfilter aufgeprägt. Das Testsignal wird hierzu insbesondere mittels Signalerzeugungsmitteln erzeugt. Das Testsignal kann beispielsweise ein amplitudenmoduliertes Signal auf einer vorgegebenen Frequenz sein oder auch ein Signal bei dem amplitudenmodulierte Signale auf mehreren Frequenzen überlagert sind.

In einem Verfahrensschritt 104 wird ein aus dem Testsignal nach Durchlaufen des Eingangsfilters resultierendes Signal mittels Erfassungsmitteln erfasst.

In einem Verfahrensschritt 105 wird das erfasste resultierende Signal ausgewertet und ein Auswertungsergebnis wird bereitgestellt.

Wird beim Auswerten in Verfahrensschritt 105 festgestellt, dass das Testsignal in dem resultierenden Signal enthalten ist und das erfasste resultierende Signal den vorgegebenen Signalpegel überschreitet, so wird mit Verfahrensschritt 106 fortgefahren. In Verfahrensschritt 106 wird ausgehend von ausgangsseitig am Stromrichter erfassten Phasenströmen ein eingangsseitiger Gleichstrom am Stromrichter bestimmt, insbesondere geschätzt. Alternativ kann vorgesehen sein, dass der eingangsseitige Gleichstrom mittels einer Sensorik erfasst wird. In einem Verfahrensschritt 107 wird zusätzlich überprüft, ob der bestimmte oder erfasste Gleichstrom einen vorgegebenen Schwellwert überschreitet.

Ist dies der Fall, so wird in einem Verfahrensschritt 108 in einem Fehlerspeicher, der beispielsweise mittels einer Steuereinrichtung der Stromrichteranordnung bereitgestellt wird, ein Status auf "Sättigungsfehler" gesetzt. In einem Verfahrensschritt 109 wird als Aktion eine Leistungsherabsetzung für eine vorgegebene erste Zeitdauer veranlasst, insbesondere für einige Sekunden. Anschließend wird zum Verfahrensschritt 100 zurückgesprungen und das Verfahren wird wiederholt.

Ist dies hingegen nicht der Fall, so wird in einem Verfahrensschritt 110 ausgehend von einem thermischen Modell des Stromrichters und des Eingangsfilters eine Temperatur von Ferritkernen des Eingangsfilters bestimmt. In einem Verfahrensschritt 111 wird überprüft, ob die bestimmte Temperatur die Curie-Temperatur der Ferritkerne überschreitet oder nicht.

Ist dies der Fall, so wird in einem Verfahrensschritt 112 in dem Fehlerspeicher der Status auf "Curie-Temperatur überschritten" gesetzt. In einem Verfahrensschritt 113 wird als Aktion eine Leistungsherabsetzung für eine vorgebebene zweite Zeitdauer veranlasst, insbesondere für mehrere Minuten. Anschließend wird zum Verfahrensschritt 100 zurückgesprungen und das Verfahren wird wiederholt.

Ist dies hingegen nicht der Fall, so wird in einem Verfahrensschritt 114 ein "Filter defekt"-Zähler um eins erhöht. In einem Verfahrensschritt 115 wird überprüft, ob der "Filter defekt"-Zähler unterhalb eines vorgegebenen Schwellwertes liegt oder nicht. Der Schwellwert kann beispielsweise 10, 30 oder 60 sein. Ist dies der Fall, so wird zum Verfahrensschritt 100 zurückgesprungen und das Verfahren wird wiederholt. Ist dies hingegen nicht der Fall, so wird in einem Verfahrensschritt 116 in einem Fehlerpuffer der Status auf "Filter defekt" gesetzt.

Wird im Verfahrensschritt 105 festgestellt, dass das Testsignal in dem resultierenden Signal enthalten ist und dass das Testsignal den vorgegebenen Signalpegel erreicht, so werden in einem Verfahrensschritt 117 die Fehlerspeicher und die Zähler gelöscht bzw. auf Null gesetzt. Anschließend wird zum Verfahrensschritt 100 zurückgesprungen und das Verfahren wird wiederholt.

Wird im Verfahrensschritt 105 festgestellt, dass das Testsignal den vorgegebenen Signalpegel nicht erreicht, so wird als Aktion in einem Verfahrensschritt 118 ein "offene Hochspannungsverbindung"-Zähler um eins erhöht. In einem Verfahrensschritt 119 wird überprüft, ob der "offene Hochspannungsverbindung"-Zähler unterhalb eines vorgegebenen Schwellwertes liegt oder nicht. Der Schwellwert kann beispielsweise 10, 30 oder 60 sein. Ist dies der Fall, so wird zum Verfahrensschritt 100 zurückgesprungen und das Verfahren wird wiederholt. Ist dies hingegen nicht der Fall, so wird in einem Verfahrensschritt 120 in einem Fehlerpuffer der Status auf "Filter defekt" gesetzt.

Das in dieser Offenbarung beschriebene Verfahren ermöglicht es insbesondere, das Eingangsfilter zu überprüfen und insbesondere selbsttätig Aktionen zu veranlassen, um Fehler (Sättigungsfehler, Temperaturfehler) zu beheben.

### Bezugszeichenliste

- 1: Stromrichteranordnung
- 2: Stromrichter
- 3: Eingangsfilter
- 4: Gleichspannungs-Hochspannungsversorgung
- 5: Signalerzeugungsmittel
- 6: Erfassungsmittel
- 7: Auswertungseinrichtung
- 8: Hochvoltbatterie
- 9: Hochspannungsverbindung
- 10: Einkoppeleinrichtung
- 11: Testsignal
- 12: Auskoppelmittel
- 13: resultierendes Signal
- 14: Auswertungsergebnis
- 15: Pulswechselrichter
- 16: Modulationssteuerung
- 17: Kommunikationsschnittstelle
- 18: Isolationswächter
- 19: konfigurierbares Netzteil
- 20: Steuereinrichtung
- 21: thermisches Modell
- 22: Überprüfungsergebnis (Curie-Temperatur)
- 23: Simulationseinrichtung
- 24: Fehlersignal
- 25: Statussignal
- 50: elektrische Maschine
- 100-120: Verfahrensschritte

## Patentansprüche

1. Verfahren zum Überwachen eines Eingangsfilters (3) eines Stromrichters (2), wobei das Eingangsfilter (3) eingangsseitig mit einer Gleichspannungs-Hochspannungsversorgung (4) verbunden ist,
wobei ein Testsignal (11) auf das Eingangsfilter (3) aufgeprägt wird,
wobei ein aus dem Testsignal (11) nach Durchlaufen des Eingangsfilters (3) resultierendes Signal (13) mittels Erfassungsmitteln (6) erfasst wird, und
wobei das erfasste resultierende Signal (13) ausgewertet wird und ein Auswertungsergebnis (14) bereitgestellt wird.

2. Verfahren nach Anspruch 1, **dadurch gekennzeichnet, dass** ausgehend von dem Auswertungsergebnis (14) mindestens eine Aktion veranlasst wird.

3. Verfahren nach Anspruch 1 oder 2, **dadurch gekennzeichnet, dass** das Auswerten ein Überprüfen umfasst, ob das Testsignal (11) in dem erfassten resultierenden Signal (13) enthalten ist.

4. Verfahren nach einem der Ansprüche 1 bis 3, **dadurch gekennzeichnet, dass** das Auswerten ein Überprüfen umfasst, ob das erfasste resultierende Signal (13) einen vorgegebenen Signalpegel aufweist.

5. Verfahren nach einem der vorangegangenen Ansprüche, **dadurch gekennzeichnet, dass** das Testsignal (11) mittels eines zum Vorladen einer Hochspannungsverbindung (9) zwischen der Gleichspannungs-Hochspannungsversorgung (4) und dem Eingangsfilter (3) verwendeten konfigurierbaren Netzteils (19) erzeugt und aufgeprägt wird.

6. Verfahren nach einem der vorangegangenen Ansprüche 2 bis 5, **dadurch gekennzeichnet, dass** ausgehend von ausgangsseitig am Stromrichter (2) erfassten Phasenströmen ein eingangsseitiger Gleichstrom am Stromrichter (2) bestimmt wird oder dass der eingangsseitige Gleichstrom mittels einer Sensorik erfasst wird, wobei zusätzlich überprüft wird, ob der bestimmte oder erfasste Gleichstrom einen vorgegebenen Schwellwert überschreitet, wobei ein Überprüfungsergebnis beim Veranlassen der mindestens einen Aktion berücksichtigt wird.

7. Verfahren nach einem der vorangegangenen Ansprüche 2 bis 6, **dadurch gekennzeichnet, dass** ausgehend von einem thermischen Modell (21) des Stromrichters (2) und des Eingangsfilters (3) eine Temperatur von Ferritkernen des Eingangsfilters (3) bestimmt wird, wobei zusätzlich überprüft wird, ob die bestimmte Temperatur die Curie-Temperatur der Ferritkerne überschreitet oder nicht, wobei ein Überprüfungsergebnis (22) beim Veranlassen der mindestens einen Aktion berücksichtigt wird.

8. Verfahren nach einem der vorangegangenen Ansprüche 2 bis 7, **dadurch gekennzeichnet, dass** als Aktion eine Leistungsherabsetzung für eine vorgegebene erste Zeitdauer veranlasst wird, sofern das Testsignal (11) in dem resultierenden Signal (13) enthalten ist und das erfasste resultierende Signal (13) den vorgegebenen Signalpegel überschreitet und der bestimmte oder erfasste Gleichstrom den vorgegebenen Schwellwert überschreitet.

9. Verfahren nach einem der vorangegangenen Ansprüche 2 bis 8, **dadurch gekennzeichnet, dass** als Aktion eine Leistungsherabsetzung für eine vorgebebene zweite Zeitdauer veranlasst wird, sofern das Testsignal (11) in dem resultierenden Signal (13) enthalten ist und das erfasste resultierende Signal (13) den vorgegebenen Signalpegel überschreitet und die Curie-Temperatur der Ferritkerne überschritten ist.

10. Verfahren nach einem der vorangegangenen Ansprüche 2 bis 9, **dadurch gekennzeichnet, dass** als Aktion ein Fehlersignal (24) erzeugt und/oder bereitgestellt wird, wenn das erfasste resultierende Signal (13) den vorgegebenen Signalpegel unterschreitet.

11. Stromrichteranordnung (1), umfassend:
einen Stromrichter (2) mit einem Eingangsfilter (3),
eine Gleichspannungs-Hochspannungsversorgung (4), welche mit dem Eingangsfilter (3) verbunden ist,
Signalerzeugungsmittel (5), die dazu eingerichtet sind, ein Testsignal (11) auf das Eingangsfilter (3) aufzuprägen,
Erfassungsmittel (6), die dazu eingerichtet sind, ein aus dem Testsignal (11) nach Durchlaufen des Eingangsfilters (3) resultierendes Signal (13) zu erfassen, und
eine Auswertungseinrichtung, die dazu eingerichtet ist, das erfasste resultierende Signal (13) auszuwerten und ein Auswertungsergebnis (14) bereitzustellen.
